# FASCICULE DE BREVET EUROPEEN

(11) **EP 4 526 920 B1**
(45) Date de publication et mention de la délivrance du brevet: **09.09.2026**
(21) Numéro de dépôt: 23723559.3
(22) Date de dépôt: 04.05.2023
(51) Int. Cl.: H10P 90/00, H10P 10/00

(54) **PROCÉDÉ DE TRANSFERT D'UNE COUCHE DEPUIS UN SUBSTRAT SOURCE VERS UN SUBSTRAT DESTINATION**
VERFAHREN ZUM ÜBERTRAGEN EINER SCHICHT VON EINEM QUELLSUBSTRAT AUF EIN ZIELSUBSTRAT
METHOD FOR TRANSFERRING A LAYER FROM A SOURCE SUBSTRATE TO A DESTINATION SUBSTRATE

(30) Priorité: 18.05.2022 FR 2204711
(43) Date de publication de la demande: 26.03.2025
(73) Titulaire: Commissariat à l'Energie Atomique et aux Energies Alternatives, 75015 Paris (FR)
(72) Inventeur: WIDIEZ, Julie, 38054 Grenoble Cedex 09 (FR); FOURNEL, Frank, 38054 Grenoble Cedex 09 (FR)
(74) Mandataire: Cabinet Beaumont
(86) Numéro de dépôt international: PCT/EP2023/061793
(87) Numéro de publication internationale: WO 2023/222399

(56) Documents cités:
- FR-A1- 3 109 016
- US-A1- 2016 233 125
- US-A1- 2022 139 768
- US-B2- 6 908 832

## Description

### Domaine technique

La présente description concerne de façon générale les procédés de fabrication de composants microélectroniques à base de matériaux semiconducteurs. Elle vise plus particulièrement un procédé de transfert d'une couche semiconductrice depuis un substrat source vers un substrat destination.

### Technique antérieure

Dans les procédés de fabrication de composants microélectroniques, des transferts de couches sont couramment utilisés pour reporter une couche semiconductrice relativement mince et de haute qualité cristalline, sur un substrat destination plus épais et de qualité cristalline inférieure ou en un matériau moins onéreux.

Après le transfert, la couche reportée peut servir de base à une étape d'épitaxie. Des composants microélectroniques peuvent ensuite être formés dans et sur la couche épitaxiée.

Il serait souhaitable de pallier au moins en partie certains inconvénients des procédés connus de transfert d'une couche semiconductrice d'un substrat source vers un substrat destination. Le document US2022/139768 décrit un procédé de transfert d'une couche depuis un substrat source vers un substrat destination comprenant les étapes : a) activer une surface de collage de ladite couche et une surface de collage du substrat destination, par gravure ionique desdites surfaces et b) après l'étape a), mettre en contact la surface de collage de ladite couche avec la surface de collage du substrat destination. Le document US6908832 divulgue une technique de collage sous vide. Les problèmes de qualité de collage des périphéries n'y sont pas mentionnés.

On s'intéresse ici plus particulièrement à l'amélioration de la qualité des bords de la couche transférée.

### Résumé de l'invention

Un mode de réalisation prévoit un procédé de transfert d'une couche depuis un substrat source vers un substrat destination, comprenant les étapes suivantes :
a) activer une surface de collage de ladite couche et une surface de collage du substrat destination, par gravure ionique desdites surfaces, ou par pulvérisation d'un matériau de collage sur lesdites surfaces ; et
b) après l'étape a), mettre en contact la surface de collage de ladite couche avec la surface de collage du substrat destination,

dans lequel, lors de l'étape a), un anneau de masquage recouvre une partie périphérique de la surface de collage de ladite couche, et/ou, un anneau de masquage recouvre une partie périphérique de la surface de collage du substrat destination ; et
dans lequel les étapes a) et b) sont réalisées sous vide et sans rupture de vide entre les deux étapes.

Selon un mode de réalisation, le substrat destination et/ ou le substrat source a des bords biseautés sur une première largeur.

Selon un mode de réalisation, l'anneau de masquage a une largeur supérieure ou égale à la première largeur.

Selon un mode de réalisation, le procédé comprend, après l'étape b), une étape c) de retrait du substrat source.

Selon un mode de réalisation, l'étape c) comprend une étape de recuit conduisant à fracturer l'assemblage obtenu à l'issue de l'étape b), dans le plan d'une couche enterrée implantée séparant ladite couche du substrat source.

Selon un mode de réalisation, ladite couche est une couche semiconductrice.

Selon un mode de réalisation, le procédé comprend, après l'étape b), une étape d'épitaxie sur et en contact avec la face de ladite couche opposée au substrat destination.

Selon un mode de réalisation, le procédé comprend, avant l'étape a), une étape de formation d'une marche en périphérie de ladite couche et/ou en périphérie du substrat destination.

Selon un mode de réalisation, ladite marche est formée par gravure ionique, en protégeant une partie centrale de la surface de collage au moyen d'un disque de masquage.

Selon un mode de réalisation, la gravure ionique de formation de ladite marche est mise en oeuvre dans le même équipement que celui utilisé à l'étape a) pour l'activation des surfaces de collage.

Selon un mode de réalisation, le procédé comprend une attente d'au moins 10 minutes et/ou un cycle d'application d'un gaz réactif entre la formation de ladite marche et l'activation des surfaces de collage.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

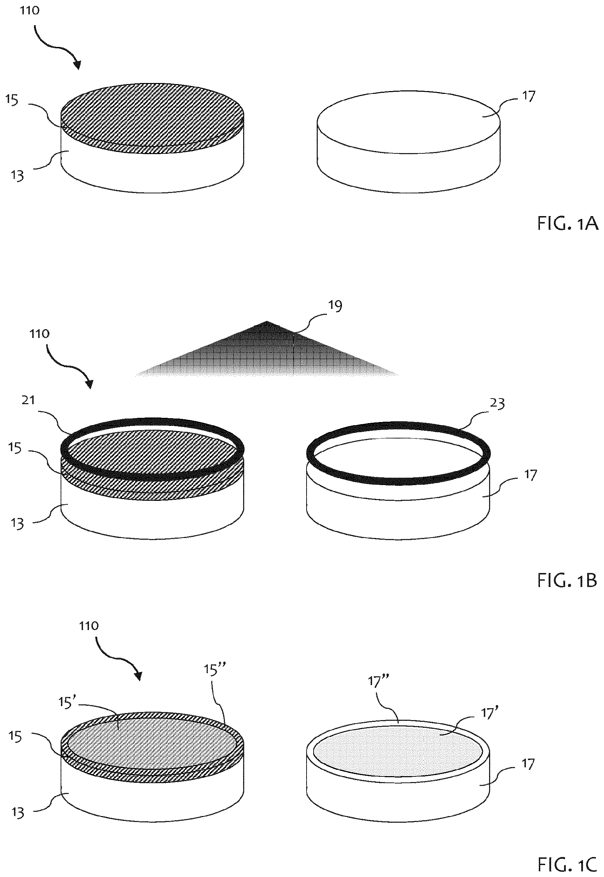

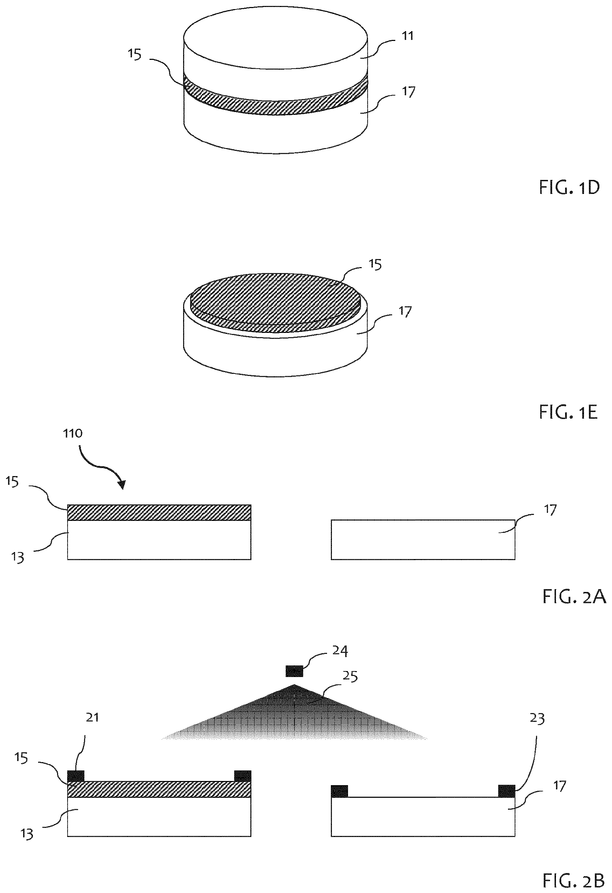

la figure 1A, la figure 1B, la figure 1C, la figure 1D et la figure 1E sont des vues en perspective, illustrant de façon partielle et schématique, des étapes successives d'un exemple de procédé de transfert d'une couche semiconductrice depuis un substrat source vers un substrat destination selon un premier mode de réalisation ;

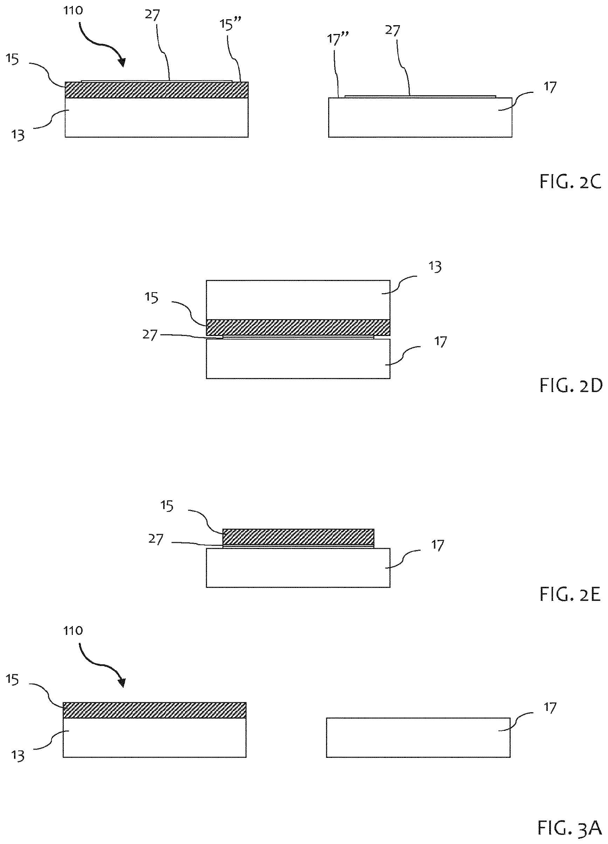

la figure 2A, la figure 2B, la figure 2C, la figure 2D et la figure 2E sont des vues en coupe, illustrant de façon partielle et schématique, des étapes successives d'un exemple de procédé de transfert d'une couche semiconductrice depuis un substrat source vers un substrat destination selon un deuxième mode de réalisation ; et

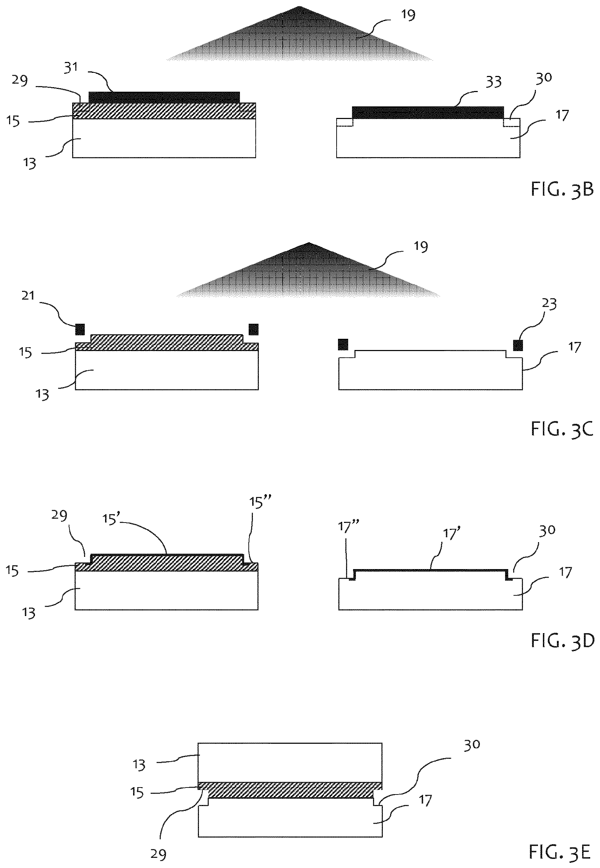

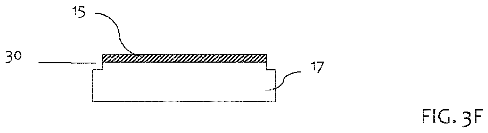

la figure 3A, la figure 3B, la figure 3C, la figure 3D, la figure 3E et la figure 3F sont des vues en coupe, illustrant de façon partielle et schématique, des étapes successives d'un exemple de procédé de transfert d'une couche semiconductrice depuis un substrat source vers un substrat destination selon un troisième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les procédés de fabrication de composants microélectroniques à partir des couches semiconductrices transférées n'ont pas été détaillés, les procédés de transfert décrits étant compatibles avec tous ou la plupart des procédés usuels de fabrication des composants microélectroniques.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

La figure 1A, la figure 1B, la figure 1C, la figure 1D et la figure 1E sont des vues en perspective, illustrant de façon partielle et schématique, des étapes successives d'un exemple de procédé de transfert d'une couche semiconductrice d'un substrat source vers un substrat destination selon un premier mode de réalisation.

La figure 1A représente, en partie gauche, une structure 110 comportant un substrat source 13 et une couche semiconductrice à transférer 15, et, en partie droite, un substrat destination 17.

La couche semiconductrice à transférer 15 est disposée sur la face supérieure du substrat 13 et, par exemple en contact avec celle-ci. La couche semiconductrice 15 s'étend par exemple de façon continue et avec une épaisseur sensiblement uniforme sur toute la surface supérieure du substrat 13. La couche semiconductrice 15 est par exemple une couche monocristalline. A titre d'exemple, la couche semiconductrice 15 est une couche de carbure de silicium (SiC), par exemple monocristallin, par exemple de type 4H-SiC. A titre de variante, la couche semiconductrice 15 est en germanium (Ge), par exemple monocristallin. Les modes de réalisation décrits ne se limitent pas à ces exemples particuliers.

Le substrat source 13 est par exemple en un matériau semiconducteur. A titre d'exemple, le substrat source 13 est en le même matériau que la couche semiconductrice 15. Les modes de réalisation décrits ne se limitent toutefois pas à ce cas particulier.

La couche à transférer 15 a, par exemple, une épaisseur comprise entre 100 nm et 10 µm, par exemple entre 300 nm et 2 µm.

Le substrat source 13 présente par exemple une épaisseur comprise entre 100 µm et 1 mm, par exemple entre 250 µm et 800 µm, par exemple de l'ordre de 350 µm.

Le substrat destination 17 peut être en un matériau semiconducteur ou en un matériau diélectrique. Le substrat destination 17 est par exemple une plaquette (wafer) semiconductrice, par exemple en silicium ou en carbure de silicium polycristallin, par exemple de type 3C-SiC.

A titre d'exemple, le substrat destination 17 et le substrat source 13 ont sensiblement la même forme et les mêmes dimensions en vue de dessus. A titre d'exemple, le substrat destination 17 et le substrat source 13 sont tous les deux, en vue de dessus, de forme circulaire et ont, par exemple le même diamètre.

Pour limiter les risques de casse, le substrat destination 17 et/ou le substrat source 13 présentent de préférence des bords biseautés ou arrondis et une zone de tombé de bords, par exemple sur une bande annulaire périphérique de largeur comprise entre 0,1 mm et 5 mm, par exemple entre 0,2 mm et 3 mm. Autrement dit, le substrat destination 17 et/ou le substrat source 13 présentent, à leur périphérie, une épaisseur décroissante en s'éloignant du centre du substrat, par exemple sur une bande annulaire périphérique de largeur comprise entre 0,1 mm et 5 mm, par exemple entre 0,2 et 3 mm.

Lors du report de la couche à transférer 15 sur le substrat destination 17, la couche à transférer 15 est mise en contact, par sa face supérieure dans l'orientation de la figure 1A, sur la face supérieure du substrat destination 17.

En pratique, et tout particulièrement dans le cas où le substrat destination 17 et/ou le substrat source 13 présentent des bords biseautés, on observe que le collage de la couche 15 sur le substrat destination 17 est incomplet en périphérie de l'assemblage. En effet, lors du report de la couche 15 sur le substrat 17, alors que la couche 15 et le substrat 17 sont bien contactés au centre de l'assemblage, ils ne le sont pas ou seulement partiellement en bordure de l'assemblage, notamment en raison du biseau périphérique des substrats, et/ou d'éventuels défauts de planéité des substrats.

A l'issue d'une étape de retrait du substrat source 13, les parties périphériques de la couche 15 non collées ou mal collées au substrat destination 17 se détachent. Ainsi, une bande annulaire périphérique du substrat destination 17 n'est pas recouverte ou seulement partiellement recouverte par la couche 15.

En l'absence de précautions particulières, à l'issue du transfert, les bords de la couche 15 en périphérie de l'assemblage sont irréguliers. Ceci est dû au fait que la limite de collage entre la couche 15 et le substrat destination 17 est irrégulière. Cette irrégularité des bords de la couche 15 peut engendrer des défauts susceptibles de se propager vers le centre de la couche 15 lors d'étapes ultérieures de fabrication de composants microélectroniques, par exemple lors d'une étape d'épitaxie à partir de la face supérieure de la couche 15. Les défauts sont en particulier susceptibles de se propager dans la couche épitaxiée sur la couche 15.

On cherche ici à améliorer la régularité ou netteté des bords de la couche 15 à l'issue du transfert.

La figure 1B illustre une étape d'activation de la surface supérieure, appelée surface de collage, de la couche 15 et de la surface supérieure, appelée surface de collage, du substrat destination 17.

Cette étape d'activation est réalisée par un procédé de gravure ou abrasion ionique consistant à envoyer sur les surfaces à activer un faisceau d'ions 19 ou d'atomes, par exemple neutres. Le faisceau 19 permet de retirer, par exemple, les éventuels oxydes en surface des surfaces à activer et former des liaisons pendantes qui serviront à former des liaisons covalentes lors de la mise en contact, dans une étape ultérieure, des surfaces activées. Un tel procédé de collage est généralement appelé collage activé en surface ou SAB (de l'anglais "Surface Activated Bonding").

Cette étape est réalisée sous vide, c'est à dire à une pression inférieure à la pression atmosphérique, par exemple sous-ultravide, par exemple sous une pression inférieure à 10⁻⁷ mbar, par exemple inférieure à 10⁻⁸ mbar.

Dans l'exemple de la figure 1B, lors de l'étape d'activation des surfaces de collage, un anneau de masquage 21 recouvre une partie périphérique de la surface de collage de la couche 15, et un anneau de masquage 23 recouvre une partie périphérique de la surface de collage du substrat destination 17. A titre d'exemple, l'anneau de masquage 21 a un diamètre externe correspondant au diamètre du substrat source 13. L'anneau de masquage 23 a par exemple un diamètre externe correspondant au diamètre du substrat destination 17. A titre d'exemple, en projection verticale, le centre de l'anneau de masquage 21 coïncide avec le centre du substrat source 13, et le centre de l'anneau de masquage 23 coïncide avec le centre du substrat destination 17. La largeur de la bande annulaire périphérique de la couche 15 masquée par l'anneau 21 est par exemple comprise entre 0,2 mm et 5,1 mm, par exemple entre 0,3 mm et 3,1 mm, par exemple de l'ordre de 0,5 mm. La largeur de la bande annulaire périphérique du substrat destination 17 masquée par l'anneau 23 est par exemple comprise entre 0,2 mm et 5,1 mm, par exemple entre 0,3 mm et 3,1 mm, par exemple de l'ordre de 0,5 mm. A titre d'exemple, les anneaux de masquage 21 et 23 sont identiques, aux dispersions de fabrication près.

Les anneaux de masquage 21 et 23 sont par exemple métalliques et/ou en un matériau semiconducteur ou isolant. A titre d'exemple, pendant l'étape d'activation des surfaces de collage par gravure ionique, l'anneau 21 est disposé sur et en contact avec la surface de collage de la couche semiconductrice 15, et l'anneau 23 est disposé sur et en contact avec la surface de collage du substrat destination 17.

Dans l'exemple représenté, l'activation de la surface de collage de la couche 15 et l'activation de la surface de collage du substrat destination 17 sont réalisées simultanément. En variante, l'activation de la surface de collage de la couche 15 et l'activation de la surface de collage du substrat destination 17 sont réalisées successivement, sans rupture de vide.

Lors de l'étape d'activation, seules les parties libres des surfaces de collage du substrat destination 17 et de la couche à transférer 15, c'est-à-dire les parties des surfaces de collage de la couche 15 et du substrat 17 qui ne sont pas recouvertes par les anneaux de masquage 21 et 23 sont activées. En particulier, les liaisons pendantes de surface destinées à former ultérieurement des liaisons covalentes pour fixer la couche 15 sur le substrat destination 17 sont formées uniquement dans les parties centrales, non recouvertes par les anneaux de masquage 21 et 23, des faces de collage de la couche 15 et du substrat destination 17. L'activation et notamment la formation de liaisons pendantes ne se produit en revanche pas dans les parties périphériques, recouvertes par les anneaux de masquage 21 et 23, des faces de collage de la couche 15 et du substrat destination 17.

La figure 1C illustre la structure 110 et le substrat destination 17 à l'issue de l'étape d'activation des surfaces de collage du substrat destination 17 et de la couche 15 et après retrait des anneaux de masquage 21 et 23.

A ce stade, une partie centrale 15' de la surface de collage de la couche 15 est activée et une partie centrale 17' de la surface de collage du substrat destination 17 est activée. Une partie périphérique 15" de la surface de collage de la couche 15 et une partie périphérique 17'' de la surface de collage du substrat destination 17 restent en revanche inactivées et ne comportent pas de liaisons pendantes permettant la création de liaisons covalentes.

La figure 1D illustre une étape de collage de la structure 110 de la figure 1C sur le substrat destination 17 de la figure 1C. Lors de cette étape, la surface de collage de la couche 15 est mise en contact avec la surface de collage du substrat destination 17.

Les liaisons pendantes formées sur la partie activée 15' de la surface de collage de la couche 15 et les liaisons pendantes formées sur la partie activée 17' de la surface de collage du substrat 17 créent, lorsqu'elles sont mises en contact, des liaisons covalentes assurant la fixation de la couche 15 sur le substrat 17.

A titre d'exemple, l'étape de collage est réalisée sous une température comprise entre 10 °C et 400 °C, par exemple entre 10 °C et 40 °C, par exemple à température ambiante.

La figure 1E illustre la structure obtenue à l'issue d'une étape de retrait du substrat source 13 de façon à conserver uniquement la couche à transférer 15 sur la surface de collage du substrat destination 17.

A titre d'exemple, le substrat 13 est en le même matériau semiconducteur que la couche 15, et une couche enterrée (non visible sur les figures) implantée, par exemple par des ions hydrogène (H+), sépare la couche 15 du substrat source 13. A titre d'exemple, la structure 110 est initialement une plaquette (wafer) semiconductrice monocristalline, que l'on vient implanter par sa face supérieure, par exemple par des ions hydrogène, de façon à créer la couche implantée enterrée séparant la couche à transférer 15 du substrat source 13. A titre d'exemple, le retrait du substrat source 13 peut comprendre une étape de recuit thermique conduisant à fracturer la structure 110 dans le plan de la couche implantée enterrée, de façon à permettre de retirer le substrat source 13 et conserver uniquement la couche 15 sur le substrat destination 17.

Plus généralement, le retrait du substrat 13 peut être réalisé par toute autre méthode connue de retrait d'un substrat source lors d'un transfert d'une couche semiconductrice d'un substrat source vers un substrat destination, par exemple par meulage, ou par un procédé de décollement laser (laser lift off).

Lors du retrait du substrat source 13, seule la zone centrale de la couche 15 située en vis-à-vis de la partie activée 15' de la surface de collage reste fixée à la partie activée 17' de la surface de collage du substrat destination 17. La partie périphérique **17'',** non activée, de la surface de collage du substrat destination 17 reste en revanche libre, c'est à dire non recouverte par la couche 15.

Ainsi, à l'issue du procédé illustré en figures 1A à 1E, la couche transférée 15 présente un bord net et régulier correspondant sensiblement au bord intérieur de l'anneau de masquage 21 mis en place lors de l'étape d'activation de la figure 1B.

Les étapes d'activation des surfaces et de collage sont réalisées sans rupture du vide. A titre d'exemple, les étapes d'activation des surfaces (figure 1B) et de collage (figure 1D) sont réalisées au sein d'un même équipement, comprenant par exemple une chambre d'activation dans laquelle est mise en oeuvre l'étape d'activation de la figure 1B, et une chambre de collage dans laquelle est mise en oeuvre l'étape de collage de la figure 1D.

En pratique, lors de l'étape de collage (figure 1D), on cherche à aligner les structures de façon à faire coïncider les surfaces activées 15' de la couche 15 et 17' du substrat 17. Toutefois, même si l'alignement n'est pas parfait, la solution proposée permet d'obtenir un bord net de la couche transférée, puisque seules les portions des surfaces activées 15' et 17' mises en contact adhèrent l'une à l'autre.

On notera que dans l'exemple illustré en figure 1B, la surface de collage de la couche 15 est activée à travers un anneau de masquage 21 et la surface de collage du substrat destination 17 est activée à travers un anneau de masquage 23. En variante, un anneau de masquage peut être prévu uniquement sur la surface de collage de la couche 15 ou uniquement sur la surface de collage du substrat destination 17. Dans ce cas, lors de la mise en contact des surfaces de collage, la fixation de la couche 15 sur le substrat destination 17 ne s'opère pas en périphérie de l'assemblage, dans la mesure où les liaisons pendantes n'auront été formées que sur l'une des deux surfaces de collage. Un avantage de cette variante est qu'elle nécessite une précision d'alignement moindre.

La figure 2A, la figure 2B, la figure 2C, la figure 2D et la figure 2E sont des vues en coupe, illustrant de façon partielle et schématique, des étapes successives d'un exemple de procédé de transfert d'une couche semiconductrice depuis un substrat source vers un substrat destination selon un deuxième mode de réalisation.

Le deuxième mode de réalisation est similaire au premier mode de réalisation illustré en figures 1A à 1E, à la différence près que, dans le deuxième mode de réalisation, l'activation des surfaces de collage est réalisée par dépôt d'une fine couche d'un matériau de collage apportant des liaisons pendantes permettant ensuite de former des liaisons covalentes lors de la mise en contact des surfaces activées. Les éléments communs avec le procédé des figures 1A à 1E ne seront pas détaillés à nouveau ci-après. Seules les différences avec le procédé des figures 1A à 1E seront mises en exergue.

La figure 2A illustre, de façon similaire à la figure 1A, en partie gauche, la structure 110 comprenant le substrat source 13 et la couche semiconductrice à transférer 15, et, en partie droite, le substrat destination 17.

La figure 2B illustre une étape d'activation de la surface supérieure, appelée surface de collage, de la couche 15 et de la surface supérieure, appelée surface de collage, du substrat destination 17.

Cette étape d'activation consiste en le dépôt d'une fine couche d'activation sur les surfaces à activer. Cela permet de créer des liaisons pendantes qui serviront à former des liaisons covalentes lors de la mise en contact des couches activées dans une étape ultérieure. Cette technique de collage, est appelée collage par diffusion atomique ou ADB (de l'anglais "Atomic Diffusion Bonding").

A titre d'exemple, lors de cette étape, un faisceau d'ions ou d'atomes, par exemple de gaz neutre, par exemple d'argon, bombarde une cible 24 en un matériau dont les atomes 25 se détachent et se déposent uniformément en une fine couche sur la ou les surfaces à activer. A titre d'exemple, la cible est métallique, par exemple, en tungstène ou en titane. En variante, la cible 24 est en un matériau semiconducteur, par exemple, en silicium, en germanium, etc.

Cette étape est réalisée sous vide, c'est à dire à une pression inférieure à la pression atmosphérique, par exemple sous-ultravide, par exemple sous une pression inférieure à 10⁻⁷ mbar, par exemple inférieure à 10⁻⁸ mbar.

De façon similaire à ce qui a été décrit précédemment, lors de l'activation, un anneau de masquage 21 recouvre la surface de collage de la couche 15 et un anneau de masquage 23 recouvre la surface de collage du substrat destination 17.

Dans l'exemple représenté, l'activation de la surface de collage de la couche 15 et l'activation de la surface de collage du substrat destination 17 sont réalisées simultanément. A titre de variante, l'activation de la surface de collage de la couche 15 et l'activation de la surface de collage du substrat destination 17 sont réalisées successivement sans rupture de vide.

De façon similaire à ce qui a été décrit précédemment, lors de l'étape d'activation, seules les parties libres des surfaces de collage du substrat destination 17 et de la couche 15, c'est-à-dire les parties des surfaces de collage de la couche 15 et du substrat 17 qui ne sont pas recouvertes par les anneaux de masquage 21 et 23 sont activées.

La figure 2C illustre la structure 110 et le substrat destination 17 à l'issue de l'étape d'activation des surfaces de collage du substrat destination 17 et de la couche 15 et après retrait des anneaux de masquage 21 et 23.

A ce stade, une partie centrale de la surface de collage de la couche 15 et une partie centrale de la surface de collage du substrat destination 17 sont activées, c'est à dire surmontées par une couche 27 en le matériau de la cible 24. A titre d'exemple, les couches 27 ont chacune une épaisseur supérieure à 0,2 nm, par exemple inférieure à 100 nm. A titre d'exemple, la ou les couches 27 ont une épaisseur comprise entre 1 nm et 20 nm.

Dans cet exemple, la périphérie 15'' de la surface de collage de la couche 15 et la périphérie 17'' de la surface de collage du substrat destination 17 ne sont pas activées, c'est à dire qu'elles ne sont pas recouvertes par la couche 27, et ne comportent par conséquent pas de liaisons pendantes permettant la création de liaisons covalentes pour fixer la couche 15 au substrat 17.

La figure 2D illustre une étape de collage de la structure 110 de la figure 2C sur le substrat destination 17 de la figure 2C. Lors de cette étape, la surface de collage de la couche 15 est mise en contact avec la surface de collage du substrat destination 17. Plus particulièrement, la couche 27 formée sur la couche 15 et la couche 27 formée sur le substrat destination 17 sont mises en contact.

Les liaisons pendantes de la couche 27 déposée sur la couche 15 et celles de la couche 27 déposée sur le substrat 17 créent, lorsqu'elles sont mises en contact, des liaisons covalentes assurant la fixation de la couche 15 sur le substrat 17.

A titre d'exemple, l'étape de collage est réalisée sous une température comprise entre 10 °C et 400 °C, par exemple comprise entre 10 °C et 40 °C, par exemple à température ambiante.

A titre d'exemple, la résistivité d'interface entre la couche 15 et le substrat destination 17 est inférieure à 10⁻³ Ω.cm⁻², par exemple, inférieure à 10⁻⁵ Ω.cm⁻². Ceci permet au collage d'être électriquement transparent.

La figure 2E illustre la structure obtenue à l'issue d'une étape de retrait du substrat source 13 de la structure illustrée en figure 2D.

Comme précédemment, lors du retrait du substrat source 13, seule la zone centrale de la couche à transférer 15 située en vis-à-vis des parties activées des surfaces de collage reste fixée au substrat destination 17. La partie périphérique 17" du substrat destination 17, située en vis à vis des parties non activées des surfaces de collage, reste en revanche libre, c'est à dire non recouverte par la couche 15.

Là encore, les étapes d'activation des surfaces de collage (figure 2B) et de collage (figure 2D) sont réalisées sans rupture de vide, par exemple au sein d'un même équipement, comprenant par exemple une chambre d'activation dans laquelle est mise en oeuvre l'étape d'activation de la figure 2B, et une chambre de collage dans laquelle est mise en oeuvre l'étape de collage de la figure 2D.

Dans l'exemple illustré en figure 2B, la surface de collage de la couche 15 est activée à travers un anneau de masquage 21 et la surface de collage du substrat destination 17 est activée à travers un anneau de masquage 23. En variante, un anneau de masquage peut être prévu sur uniquement la surface de collage de la couche 15 ou uniquement sur la surface de collage du substrat destination 17. Dans ce cas, lors de la mise en contact des surfaces de collage, la fixation de la couche 15 sur le substrat destination 17 ne s'opère pas en périphérise de l'assemblage, dans la mesure où les liaisons pendantes n'auront été formées que sur l'une des deux surfaces de collage.

En pratique, lors de l'étape de collage, on cherche à aligner les structures de façon à faire coïncider les surfaces activées des deux structures. Toutefois, même si l'alignement n'est pas parfait, la solution proposée permet d'obtenir un bord net de la couche transférée, puisque seules les portions des surfaces activées mises en contact adhèrent l'une à l'autre.

La figure 3A, la figure 3B, la figure 3C, la figure 3D, la figure 3E et la figure 3F sont des vues en coupe, illustrant de façon partielle et schématique, des étapes successives d'un exemple de procédé de transfert d'une couche semiconductrice depuis un substrat source 13 vers un substrat destination 17 selon un troisième mode de réalisation.

Le troisième mode de réalisation est similaire au premier mode de réalisation illustré en figures 1A à 1E, à la différence près qu'il comprend, une étape de gravure d'une marche sur la périphérie du substrat destination 17 et sur la périphérie de la couche 15 avant l'étape de collage de la couche 15 sur le substrat 17. Les éléments communs avec le procédé des figures 1A à 1E ne seront pas détaillés à nouveau ci-après. Seules les différences avec le procédé des figures 1A à 1E seront mises en exergue.

La figure 3A illustre, de façon similaire à la figue 1A, en partie gauche, la structure 110 comprenant le substrat source 13 et la couche semiconductrice 15 à transférer, et, en partie droite, le substrat destination 17.

La figure 3B illustre une étape de gravure d'une marche 30, sur la périphérie de la face supérieure du substrat destination 17 et d'une marche 29 sur la périphérie de la face supérieure de la couche 15.

Les marches 29 et 30 sont réalisées par un procédé de gravure ou abrasion ionique consistant à envoyer sur les zones à graver un faisceau d'ions 19 ou d'atomes, par exemple neutres. Cette étape est réalisée sous vide, c'est à dire à une pression inférieure à la pression atmosphérique, par exemple sous-ultravide, par exemple sous une pression inférieure à 10⁻⁷ mbar, par exemple inférieure à 10⁻⁸ mbar.

Lors de l'étape de gravure, seules les parties libres des faces supérieures du substrat destination 17 et de la couche 15, c'est-à-dire les parties de la face supérieure de la couche 15 et du substrat destination 17 qui ne sont pas recouvertes par un masque sont gravées.

Dans l'exemple, de la figure 3B, afin de ne former une marche 29 que sur la périphérie de la surface de collage de la couche 15 et une marche 30 que sur la périphérie de la surface de collage du substrat destination 17, les parties centrales des surfaces de collage sont chacune recouvertes par un disque de masquage. Ainsi, lors de l'étape de gravure, un disque de masquage 31 recouvre une partie centrale de la surface de collage de la couche 15 et un disque de masquage 33 recouvre une partie centrale de la surface de collage du substrat destination 17.

A titre d'exemple, en projection verticale, le centre du disque de masquage 31 coïncide avec le centre du substrat source 13, et le centre du disque de masque 33 coïncide avec le centre du substrat destination 17. A titre d'exemple, le diamètre du disque de masquage 31 est inférieur au diamètre du substrat source 13 et le diamètre du disque de masquage 33 est inférieur au diamètre du substrat destination 17. La différence entre le diamètre du substrat source 13 et le diamètre du disque de masquage 31 est, par exemple comprise entre 0,2 mm et 5 mm, par exemple entre 0,5 mm et 3 mm, par exemple de l'ordre de 1 mm. La différence entre le diamètre du substrat destination 17 et le diamètre du disque de masquage 33 est, par exemple comprise entre 0,2 mm et 5 mm, par exemple entre 0,5 mm et 3 mm, par exemple de l'ordre de 1 mm. A titre d'exemple, les disques de masquage 31 et 33 sont identiques, aux dispersions de fabrication près.

Les disques de masquage 31 et 33 sont, par exemple, métalliques et/ou en un matériau semiconducteur ou isolant. A titre d'exemple, pendant l'étape de gravure des marches 29 et 30, le disque de masquage 31 est disposé sur et en contact avec la face supérieure de la couche semiconductrice 15, et le disque de masquage 33 est disposé sur et en contact avec la face supérieure du substrat destination 17.

Dans l'exemple représenté, la gravure de la marche 29 dans la couche 15 et la gravure de la marche 30 dans le substrat destination 17 sont réalisées simultanément. En variante, la gravure de la marche 29 dans la couche 15 et la gravure de la marche 30 dans le substrat destination 17 sont réalisées successivement.

A titre d'exemple, la marche 29 a une profondeur, à partir de la face supérieure de la couche 15, supérieure à environ 10 nm, par exemple supérieure à environ 50 nm. A titre d'exemple, la marche 30 a une profondeur, à partir de la face supérieure du substrat 17, supérieure à environ 10 nm, par exemple supérieure à environ 50 nm. A titre d'exemple, de par la nature différente de la couche 15 et du substrat 17, la marche 29 et la marche 30 n'ont pas la même profondeur.

A l'issue de cette étape, les disques de masquage 31 et 33 sont retirés.

La figure 3C illustre une étape d'activation des surfaces de collage de la couche 15 et du substrat destination 17.

Le procédé mis en oeuvre lors de cette étape est un procédé de gravure ou abrasion ionique similaire au procédé mis en oeuvre lors de la formation des marches 29 et 30. L'énergie de gravure et/ou le temps de gravure sont toutefois inférieurs à l'énergie de gravure et/ou au temps de gravure mis en oeuvre lors de la formation des marches 29 et 30 de façon à activer les surfaces exposées sans graver une épaisseur significative de la couche 15 et du substrat 17. Lors de cette étape, le faisceau d'ions 19 ou d'atomes, par exemple neutres envoyés sur les surfaces à activer permet de retirer, par exemple, les éventuels oxydes présents en surface des faces à activer en laissant des liaisons pendantes qui serviront à former des liaisons covalentes lors de la mise en contact des surfaces activées dans une étape ultérieure. A titre d'exemple, lors de cette étape, le retrait de matière des surfaces à activer est inférieur à quelques nanomètres, par exemple inférieure à 5 nm. En tout état de cause, l'épaisseur de matière retirée lors de cette étape d'activation est inférieure à l'épaisseur retirée lors de la formation des marches 29 et 30.

A titre d'exemple, lors de l'étape illustrée en figure 3C, le temps d'exposition des surfaces est, par exemple diminué et/ou la puissance du faisceau 19 d'ions est, par exemple diminuée par rapport à l'étape illustrée en figure 3B.

De façon similaire à ce qui a été décrit précédemment en relation avec la figure 1B, lors de l'activation, un anneau de masquage 21 recouvre la surface de collage de la couche 15 et un anneau de masquage 23 recouvre la surface de collage du substrat destination 17.

Dans l'exemple représenté, l'activation de la surface de collage de la couche 15 et l'activation de la surface de collage du substrat destination 17 sont réalisées simultanément. L'activation de la surface de collage de la couche 15 et l'activation de la surface de collage du substrat destination 17 sont réalisées successivement sans rupture de vide.

De façon similaire à ce qui a été décrit précédemment, lors de l'étape d'activation, seules les parties libres des surfaces de collage du substrat destination 17 et de la couche 15, c'est-à-dire les parties des surfaces de collage de la couche 15 et du substrat 17 qui ne sont pas recouvertes par un anneau de masquage 21 sont activées.

A titre d'exemple, le disque de masquage 21 a un diamètre intérieur supérieur ou égal au diamètre du disque 31. Similairement, le disque de masquage 23 a un diamètre intérieur supérieur ou égal au diamètre du disque 33. Ainsi, la couche 15 comprend une partie libre dans la marche 29 et le substrat 17 comprend une partie libre dans la marche 30. Ces parties libres dans les marches 29 et 30 sont alors activées lors de cette étape.

A titre d'exemple, l'étape de gravure des marches 29 et 30 (figure 3B) et l'étape d'activation des surfaces de collage à travers les anneaux de masquage (figure 3C) sont séparées de quelques minutes, par exemple au moins quinze minutes, de façon à réduire l'activation de la couronne gravée à l'étape de la figure 3B. Cette attente peut être mise en oeuvre sans rupture de vide entre les deux étapes. A titre de variante, cette attente peut être remplacée par un cycle de remise de la chambre, ou d'une partie de la chambre, par exemple avec l'utilisation d'un sas de transfert, à une pression supérieure, par exemple à pression atmosphérique, par exemple sous une atmosphère contenant un gaz réactif comme l'azote ou l'oxygène. Là encore, ceci permet de réduire l'activation de la couronne gravée, c'est à dire de neutraliser des liaisons pendantes à la surface de la couronne gravée.

La figure 3D illustre la structure 110 et le substrat destination 17 à l'issue de l'étape d'activation des faces supérieures du substrat destination 17 et de la couche 15 et après le retrait des anneaux de masquage 21 et 23.

A ce stade, une partie centrale 15' de la surface de collage de la couche 15 qui se prolonge dans la marche 29 et une partie centrale 17' de la surface de collage du substrat destination 17 qui se prolonge dans la marche 30 sont activées. Une partie périphérique 15" de la surface de collage de la couche 15 et une partie périphérique 17'' de la surface de collage du substrat destination 17 restent en revanche inactives et ne comportent pas de liaisons pendantes permettant la création de liaisons covalentes. A titre d'exemple les parties périphériques 15'' et 17'' sont respectivement situées dans les marches 29 et 30. A titre d'exemple, la partie périphérique 15" s'étend sur une largeur inférieure à la largeur de la marche 29 et similairement, la partie périphérique 17" s'étend, par exemple, sur une largeur inférieure à la largeur de la marche 30.

La figure 3E illustre une étape de collage de la structure 110 sur le substrat destination 17. Lors de cette étape, la surface de collage de la couche 15 est mise en contact avec la surface de collage du substrat destination 17. A la différence de l'étape de collage illustrée en figure 1D, en figure 3E seule une zone centrale de la surface de collage de la couche 15, délimitée par la marche 29 est mise en contact d'une zone centrale de la surface de collage du substrat 17, délimitée par la marche 30.

Les liaisons pendantes formées sur la partie activée 15' de la surface de collage de la couche 15 et les liaisons pendantes formées sur la partie activée 17' de la surface de collage du substrat 17 créent, lorsqu'elles sont mises en contact, des liaisons covalentes assurant la fixation de la couche 15 sur le substrat 17.

A titre d'exemple, l'étape de collage est réalisée sous une température comprise entre 10 °C et 400 °C, par exemple entre 10 °C et 40 °C, par exemple à température ambiante.

La figure 3F illustre la structure obtenue à l'issue d'une étape de retrait du substrat source 13 de la structure illustrée en figure 3E.

Lors du retrait du substrat source 13, seule la zone centrale de la couche à transférer 15 située à la fois en vis-à-vis des parties activées des surfaces de collage et hors du vis-à-vis des marches 29 et 31 reste fixée au substrat destination 17. La partie périphérique du substrat destination 17, située en vis-à-vis des marches 29 et 30 reste en revanche libre, c'est-à-dire non recouverte par la couche 15.

Là encore, les étapes d'activation des surfaces de collage (figure 3C) et de collage (figure 3E) sont réalisées sans rupture de vide, par exemple au sein d'un même équipement, comprenant par exemple, une chambre d'activation dans laquelle est mise en oeuvre l'étape de gravure de la figure 3B et l'étape d'activation de la figure 3C, et une chambre de collage dans laquelle est mise en oeuvre l'étape de collage de la figure 3E.

Dans l'exemple illustré en figure 3B, la gravure de la couche 15 est réalisée à travers un disque de masquage 31 de sorte à former une marche 29 dans la couche 15 et la gravure du substrat destination 17 est réalisée à travers un disque de masquage 33 de sorte à former une marche 30 dans le substrat destination 17. En variante, un disque de masquage peut être prévu uniquement sur la couche 15 ou uniquement sur le substrat destination 17 de façon à former une marche sur une seule des deux surfaces de collage.

De plus, dans l'exemple illustré en figure 3C, la surface de collage de la couche 15 est activée à travers un anneau de masquage 21 et la surface de collage du substrat destination 17 est activée à travers un anneau de masquage 23. En variante, un anneau de masquage peut être prévu sur uniquement la surface de collage de la couche 15 ou uniquement sur la surface de collage du substrat destination 17. Dans ce cas, lors de la mise en contact des surfaces de collage, la fixation de la couche 15 sur le substrat destination 17 ne s'opère pas en périphérie de l'assemblage, dans la mesure où les liaisons pendantes n'auront été formées que sur l'une des deux surfaces de collage.

Un avantage du procédé des figures 3A à 3F est que la gravure des marches 29 et/ou 30 permet d'améliorer la netteté de la limite entre la zone centrale collée et la zone périphérique non collée de la couche 15. Du fait de la délimitation des surfaces de collage par les anneaux de masquage 21 et/ou 23, les marches 29 et/ou 30 peuvent toutefois être relativement peu profondes, par exemple de profondeur inférieure à 500 nm et de préférence inférieure à 100 nm.

Un exemple plus détaillé de mise en oeuvre du procédé des figures 2A à 2E va maintenant être décrit. Dans cet exemple, on propose de transférer une couche monocristalline de 4H-SiC d'un substrat source en 4H-SiC sur un substrat destination correspondant à une plaque 3C-SiC polycristallin. Dans cet exemple, une couche enterrée est implantée dans une plaque 4H-SiC avec des ions d'hydrogène, la couche enterrée délimitant la couche à transférer sur le substrat destination. L'étape d'implantation est par exemple réalisée avec une dose de l'ordre de 5.10¹⁶ at/cm² et une énergie de l'ordre de 95 keV. Toujours dans cet exemple, à la suite de l'étape d'implantation, la plaque de 4H-SiC et la plaque de 3C-SiC subissent une étape de nettoyage permettant l'élimination de contaminants surfaciques. A la suite de l'étape de nettoyage, les deux plaques sont introduites dans une chambre de dépôt de l'équipement ADB dans laquelle elles voient chacune leur face supérieure revêtue d'un film de silicium déposé, à travers un masque annulaire masquant sa partie périphérique sur une largeur de l'ordre de 1 mm. Dans cet exemple, le masque annulaire est en silice fondue. Cette étape est réalisée à température ambiante sous ultra vide correspondant à une pression de l'ordre de 10⁻⁶ Pa (c'est-à-dire 10⁻⁸ mbar). A l'issue de cette étape, chacune des deux plaques 4H-SiC et 3C-SiC a sa face supérieure recouverte d'un film de silicium d'une épaisseur supérieure à 1 nm et inférieure à 20 nm sur l'intégralité de sa face supérieure à l'exclusion d'un anneau de l'ordre de 1 mm de largeur au bord de la plaque. Sans rupture de vide et dans une autre chambre de collage, les deux plaques sont collées en prenant soin de mettre en contact les films de silicium formés sur chacune des deux plaques 4H-SiC et 3C-SiC. L'ensemble collé est ensuite soumis à un traitement thermique afin de provoquer une fracture, dans la plaque 4H-SiC, entre la couche à transférer et le substrat source au niveau de la couche enterrée et ainsi retirer le substrat source. Le traitement thermique est par exemple réalisé à environ 900 °C pendant environ 30 minutes. Des étapes de polissage et/ou nettoyage peuvent être prévues avant de soumettre la structure formée du substrat destination et de la couche à transférer à un nouveau recuit de l'ordre de 1700 °C pendant environ 30 minutes.

Un exemple plus détaillé de mise en oeuvre du procédé des figures 3A à 3F va maintenant être décrit. Dans cet exemple, on propose de transférer un film en germanium d'un substrat source correspondant à une plaque en germanium sur un substrat destination correspondant à une plaque de silicium. Dans cet exemple, une couche enterrée est implantée dans la plaque de germanium avec des ions d'hydrogène, la couche enterrée délimitant la couche à transférer du substrat destination. L'étape d'implantation est réalisée avec une dose de l'ordre de 5.5.10¹⁶ at/cm² et une énergie d'environ 100 keV. Toujours dans cet exemple, à la suite de l'étape d'implantation, la plaque de silicium et la plaque de germanium sont introduites dans une chambre d'activation de l'équipement SAB sous ultravide (c'est-à-dire inférieur à 10⁻⁷ mbar) dans laquelle leurs faces supérieures sont gravées, chacune à travers un disque, en silicium, dont le diamètre est inférieur d'environ 3 mm, au diamètre des plaques. La gravure est réalisée alors que les plaques sont en rotation, par exemple avec une vitesse de l'ordre de 70 rpm. La gravure est réalisée sous un flux d'argon ayant une énergie de l'ordre de 200 eV avec une intensité de l'ordre de 150 mA pendant environ 10 minutes. A l'issue de l'étape de gravure, les deux plaques passent dans un sas de transfert (load port) lequel la pression monte à 500 mbar grâce à un flux d'azote avant de redescendre sous-ultravide grâce à une purge par flux d'argon à 500 mbar. Les plaques reviennent ensuite dans la chambre d'activation sous-ultravide. Les faces supérieures des deux plaques sont ensuite chacune activée, à travers un masque annulaire, en silicium, masquant sa partie périphérique sur une largeur de l'ordre de 2,5 mm, par des atomes d'argon ayant une énergie d'environ 200 eV et une intensité de l'ordre de 150 mA et ce pendant une minute. Sans rupture de vide et dans une autre chambre de collage, les deux plaques sont collées en prenant soin de mettre en contact les faces activées de chacune des deux plaques germanium et silicium. L'étape de collage est opérée sous une température d'environ 250 °C sous ultravide. L'ensemble collé est ensuite soumis à un traitement thermique afin de provoquer une fracture, dans la plaque de germanium, entre la couche à transférer et le substrat source au niveau de la couche enterrée et ainsi retirer le substrat source. Le traitement thermique est par exemple réalisé à environ 330 °C pendant environ 10 heures. Dans cet exemple, un film de germanium d'environ 800 nm est transféré sur le silicium.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la présente description.

Par ailleurs, les modes de réalisation des figures 2A à 2E et 3A à 3F peuvent être combinés. Plus précisément, l'activation des surfaces lors de l'étape illustrée en figure 3C peut être effectuée suivant le procédé d'activation décrit en relation avec la figure 2B.

De plus, les modes de réalisations ont été décrits pour des substrats source et destination circulaires toutefois ils peuvent avoir une forme différente.

Encore, bien que les procédés proposés soit avantageux pour le transfert d'une couche semiconductrice d'un substrat source vers un substrat destination, ils peuvent également être mis en oeuvre pour transférer des couches de natures différentes comme des couches métalliques ou des couches diélectriques d'un substrat source vers un substrat destination.

Par ailleurs, dans les modes de réalisations décrits, l'anneau de masquage peut être remplacé par un cadre ou un anneau ovoïde. De plus, les bords de l'anneau de masquage peuvent être ondulés et ne pas avoir la forme d'un cercle.

Enfin, la mise en oeuvre pratique des modes de réalisation et variantes décrits est à la portée de la personne du métier à partir des indications fonctionnelles données ci-dessus.

## Revendications

1. Procédé de transfert d'une couche (15) depuis un substrat source (13) vers un substrat destination (17), comprenant les étapes suivantes :
a) activer une surface de collage de ladite couche (15) et une surface de collage du substrat destination (17), par gravure ionique desdites surfaces, ou par pulvérisation d'un matériau de collage (27) sur lesdites surfaces ; et
b) après l'étape a), mettre en contact la surface de collage de ladite couche (15) avec la surface de collage du substrat destination (17),
**caractérisé en ce que**
lors de l'étape a), un anneau de masquage (21) recouvre une partie périphérique (15'') de la surface de collage de ladite couche (15), et/ou, un anneau de masquage (23) recouvre une partie périphérique (17'') de la surface de collage du substrat destination (17) ; et
dans lequel les étapes a) et b) sont réalisées sous vide et sans rupture de vide entre les deux étapes.

2. Procédé selon la revendication 1, dans lequel le substrat destination (17) et/ ou le substrat source (13) a des bords biseautés sur une première largeur.

3. Procédé selon la revendication 2, dans lequel l'anneau de masquage a une largeur supérieure ou égale à la première largeur.

4. Procédé selon l'une quelconque des revendications 1 à 3, comportant, après l'étape b), une étape c) de retrait du substrat source (13).

5. Procédé selon la revendication 4, dans lequel l'étape c) comprend une étape de recuit conduisant à fracturer l'assemblage obtenu à l'issue de l'étape b), dans le plan d'une couche enterrée implantée séparant ladite couche (15) du substrat source (13).

6. Procédé selon l'une quelconque des revendications 1 à 5, dans lequel ladite couche (15) est une couche semiconductrice.

7. Procédé selon la revendication 6 dans son rattachement à la revendication 4, comprenant, après l'étape c), une étape d'épitaxie sur et en contact avec la face de ladite couche (15) opposée au substrat destination (17).

8. Procédé selon l'une quelconque des revendications 1 à 7, comportant, avant l'étape a), une étape de formation d'une marche (29, 30) en périphérie de ladite couche (15) et/ou en périphérie du substrat destination (17).

9. Procédé selon la revendication 8, dans lequel ladite marche (29, 30) est formée par gravure ionique, en protégeant une partie centrale de la surface de collage au moyen d'un disque de masquage.

10. Procédé selon la revendication 9, dans lequel la gravure ionique de formation de ladite marche (29, 30) est mise en oeuvre dans le même équipement que celui utilisé à l'étape a) pour l'activation des surfaces de collage.

11. Procédé selon la revendication 10, comprenant une attente d'au moins 10 minutes et/ou un cycle d'application d'un gaz réactif entre la formation de ladite marche (29, 30) et l'activation des surfaces de collage.

## Patentansprüche

1. Ein Verfahren zum Übertragen einer Schicht (15) von einem Quellsubstrat (13) auf ein Zielsubstrat (17), das die folgenden Schritte aufweist:
a ) Aktivieren einer Verbindungsoberfläche der Schicht (15) und einer Verbindungsoberfläche des Zielsubstrats (17) durch Ionenätzen der genannten Oberflächen oder durch Aufsputtern eines Verbindungsmaterials (27) auf die genannten Oberflächen; und
b) nach Schritt a), Inkontaktbringen der Verbindungsoberfläche der Schicht (15) mit der Verbindungsoberfläche des Zielsubstrats (17),
**dadurch gekennzeichnet, dass** während Schritt a) ein Maskierungsring (21) einen peripheren Abschnitt (15") der Verbindungsoberfläche der Schicht (15) abdeckt und/oder ein Maskierungsring (23) einen peripheren Abschnitt (17") der Verbindungsoberfläche des Zielsubstrats (17) abdeckt; und
wobei die Schritte a) und b) unter Vakuum und ohne Unterbrechen des Vakuums zwischen den beiden Schritten durchgeführt werden.

2. Das Verfahren nach Anspruch 1, wobei das Zielsubstrat (17) und/oder das Quellsubstrat (13) abgeschrägte Kanten über eine erste Breite aufweist.

3. Das Verfahren nach Anspruch 2, wobei der Maskierungsring eine Breite aufweist, die größer als oder gleich der ersten Breite ist.

4. Das Verfahren nach einem der Ansprüche 1 bis 3, aufweisend nach Schritt b) einen Schritt c) des Entfernens des Quellsubstrats (13).

5. Das Verfahren nach Anspruch 4, wobei Schritt c) einen Temperschritt aufweist, der zu einem Brechen der in Schritt b) erhaltenen Anordnung in der Ebene einer implantierten vergrabenen Schicht führt, die die Schicht (15) von dem Quellsubstrat (13) trennt.

6. Das Verfahren nach einem der Ansprüche 1 bis 5, wobei die Schicht (15) eine Halbleiterschicht ist.

7. Das Verfahren nach Anspruch 6 in Abhängigkeit von Anspruch 4, aufweisend nach Schritt c) einen Schritt von epitaktischem Wachstum auf und in Kontakt mit der Oberfläche der Schicht (15), die dem Zielsubstrat (17) gegenüberliegt.

8. Das Verfahren nach einem der Ansprüche 1 bis 7, aufweisend vor Schritt a) einen Schritt des Ausbildens einer Stufe (29, 30) an der Peripherie der Schicht (15) und/oder an der Peripherie des Zielsubstrats (17).

9. Das Verfahren nach Anspruch 8, wobei die Stufe (29, 30) durch Ionenätzen ausgebildet wird, indem ein zentraler Abschnitt der Verbindungsoberfläche mittels einer Maskierungsscheibe geschützt wird.

10. Das Verfahren nach Anspruch 9, wobei das Ionenätzen zum Ausbilden der Stufe (29, 30) in derselben Einrichtung durchgeführt wird wie die in Schritt a) zum Aktivieren der Verbindungsoberflächen verwendete Einrichtung.

11. Das Verfahren nach Anspruch 10, aufweisend eine Wartezeit von wenigstens 10 Minuten und/oder einen Zyklus des Aufbringens eines Reaktivgases zwischen dem Ausbilden der Stufe (29, 30) und dem Aktivieren der Verbindungsoberflächen.

## Claims

1. Method of transferring a layer (15) from a source substrate (13) to a destination substrate (17), comprising the following steps:
a) activating a bonding surface of said layer (15) and a bonding surface of the destination substrate (17), by ion etching of said surfaces, or by sputtering of a bonding material (27) onto said surfaces; and
b) after step a), placing into contact the bonding surface of said layer (15) with the bonding surface of the destination substrate (17),
**characterized in that**, during step a), a masking ring (21) covers a peripheral portion (15") of the bonding surface of said layer (15), and/or a masking ring (23) covers a peripheral portion (17") of the bonding surface of the destination substrate (17); and
wherein steps a) and b) are carried out under vacuum and with no rupture of vacuum between the two steps.

2. Method according to claim 1, wherein the destination substrate (17) and/or the source substrate (13) has tapered edges across a first width.

3. Method according to claim 2, wherein the masking ring has a width greater than or equal to the first width.

4. Method according to any of claims 1 to 3, comprising, after step b), a step c) of removal of the source substrate (13).

5. Method according to claim 4, wherein step c) comprises an anneal step resulting in fracturing the assembly obtained at step b), in the plane of an implanted buried layer separating said layer (15) from the source substrate (13).

6. Method according to any of claims 1 to 5, wherein said layer (15) is a semiconductor layer.

7. Method according to claim 6 as dependent on claim 4, comprising, after step c), a step of epitaxy on top of and in contact with the surface of said layer (15) opposite to the destination substrate (17).

8. Method according to any of claims 1 to 7, comprising, before step a), a step of forming of a step (29, 30) at the periphery of said layer (15) and/or at the periphery of the destination substrate (17).

9. Method according to claim 8, wherein said step (29, 30) is formed by ion etching, by protecting a central portion of the bonding surface by means of a masking disk.

10. Method according to claim 9, wherein the ion etching for forming said step (29, 30) is implemented in the same equipment as that used at step a) for the activation of the bonding surfaces.

11. Method according to claim 10, comprising a waiting period of at least 10 minutes and/or a cycle of application of a reactive gas between the forming of said step (29, 30) and the activation of the bonding surfaces.
